# EUROPEAN PATENT APPLICATION

(11) **EP 1 731 975 A1**
(43) Date of publication of application: **13.12.2006**
(21) Application number: 05710022.4
(22) Date of filing: 09.02.2005
(51) Int. Cl.: G03H 1/02, G03F 7/004, G03F 7/038

(54) **VOLUME HOLOGRAM RECORDING MATERIAL AND VOLUME HOLOGRAM RECORDING MEDIUM**

(30) Priority: 13.02.2004 JP 2004037505
(71) Applicant: TOAGOSEI CO., LTD., Tokyo 105-8419 (JP)
(72) Inventor: YACHI, Kentarou, Nagoya-city, Aichi 4550027 (JP); SATOU, Shin, Nagoya-city, Aichi 4550027 (JP); HATTORI, Satoshi, Nagoya-city, Aichi 4550027 (JP); OKAZAKI, Eiichi, Nagoya-city, Aichi 4550027 (JP)
(74) Representative: Pohlmann, Eckart
(86) International application number: PCT/JP2005/001970
(87) International publication number: WO 2005/078531

(57) **Abstract**

A volume hologram recording material is provided that has high sensitivity, good storage stability after recording, and a large interference fringe refractive index difference, the material being used for forming a volume hologram recording film desirable as a data recording system. A volume hologram recording medium comprising same is also provided.

The volume hologram recording material is a polymer matrix having a three-dimensional crosslinking structure having a plurality of reactive groups, the polymer matrix being capable of recording, by means of refractive index difference, interference fringes that result from the interference of coherent light, the material not having a polymerizable monomer as a constituent.

## Description

The present invention relates to a material suitable for volume holographic recording and a recording medium useful for a holographic data recording system.

In a hologram, a pattern formed from two interference fringes is recorded on a photosensitive material, and by shining laser light thereon from the same direction as a reference light, a replica stereoimage is reproduced at a position where an original subject was present. This hologram technique has promise in the fields of three-dimensional image display devices and large capacity memories for image or bit information.

Holograms are classified into several types according to the recording configuration of interference fringes. In recent years, the so-called volume hologram in which interference fringes are recorded by utilizing differences in refractive index inside a recording layer has been put into practical use in three-dimensional displays and optical devices because of high diffraction efficiency and excellent wavelength selectivity. With regard to photosensitive materials for recording such volume holograms, silver halide and dichromated gelatin have been used conventionally, but since they require wet development or a complicated development fixation treatment, they are not suitable for the industrial production of holograms, and there is also the problem that images might disappear after being recorded due to moisture absorption.

With regard to photosensitive materials for the volume holograms, in which interference fringes of light are recorded as fringes of refractive index difference, in recent years various types of photopolymer materials have been proposed. Since they do not require any complicated development treatment, which is needed when using conventional silver salt photosensitive materials or dichromated gelatin, and a volume hologram can be recorded merely by a dry process, they can be said to be useful for the industrial production of holograms.

With regard to a photosensitive composition used for producing a volume hologram, there is one, as disclosed in JP-B-6-100827 (JP-B denotes a Japanese examined Patent application publication), that has as main components a radically polymerizable monomer, a binder polymer, a radical photopolymerization initiator, and a sensitizing dye, and utilizes a difference in refractive index between the radically polymerizable monomer and the binder polymer. That is, when a film formed from this photosensitive composition is subjected to interference exposure, radical polymerization is initiated in an area in which the light is strong, this results in a concentration gradation of the radically polymerizable monomer, and the radically polymerizable monomer diffuses from an area where light is weak to an area where light is strong. As a result, the concentration of the radically polymerizable monomer varies according to the intensity of the interference light, thus causing a difference in refractive index. However, since in this material system the binder polymer is thermoplastic, there are problems in terms of heat resistance and storage stability after exposure, and the transparency is poor.

Furthermore, a material system employing a combination of radical polymerization and cationic polymerization has been reported. For example, Japanese registered Patent No. 2873126 discloses a system employing a monomer having a diarylfluorene framework as a high refractive index radically polymerizable monomer and a cationically polymerizable monomer having a refractive index that is smaller than that of the radically polymerizable monomer. In this system, the high refractive index component undergoes radical polymerization during hologram exposure, and an image is subsequently fixed by cationic polymerization during exposure for fixation, but the sensitivity during the hologram exposure is insufficient.

Furthermore, a material system employing cationic polymerization is disclosed in, for example, Published Japanese translation No. 2001-523842 of a PCT application. Although there are the advantages that a recorded hologram has high dimensional stability since this material system has a low curing shrinkage, and polymerization is not inhibited by oxygen, there are the disadvantages that storage stability before exposure is poor and recording speed depends greatly on temperature. Furthermore, since in order to improve the ability to modulate the refractive index a nonreactive plasticizer, etc. is used, there is a problem with the coating strength of the hologram formed, and in addition the refractive index modulation is not sufficient.

In JP-A-5-107999 (JP-A denotes a Japanese unexamined patent application publication), there is proposed, as a photosensitive material for forming a recording layer, a photopolymer system composition, that is, a composition comprising (a) a cationically polymerizable compound, (b) a radically polymerizable compound, (c) a radical photopolymerization initiator system component for polymerizing the above (b), and (d) a cationic polymerization initiator system component for polymerizing the above (a), the average refractive index of the above (a) being lower than the average refractive index of the above (b), and it is reported that in accordance with this composition, a hologram having an excellent diffraction effect, wavelength selectivity, refractive index modulation, coating strength, etc., can be obtained.

However, when forming a recording layer of a volume hologram, it is normally necessary to employ a step of dissolving in a solvent and drying, and the recording layer easily becomes nonuniform due to the occurrence of voids, etc., which are not desirable for industrial production. Furthermore, it is difficult to form an injection type recording layer in which transparent substrates are laminated via a spacer.

With regard to one in which an injection type recording layer is easily formed, JP-A-11-352303 discloses an optical product comprising a three-dimensional crosslinking polymer matrix and one or a plurality of photoactive monomers, at least one type of photoactive monomer comprising, in addition to a monomer functional group, a moiety that is substantially absent in the polymer matrix, and a polymer formed by polymerization of said one or plurality of photoactive monomers being compatible with the matrix polymer. In this system, the three-dimensional crosslinking polymer matrix is formed by injecting between transparent substrates a precursor for the three-dimensional crosslinking polymer matrix and crosslinking it. In this process, since the monomer is independent of the crosslinking reaction and is inactive, it is not incorporated into the matrix. However, in order to impart transparency, not only is it necessary for the three-dimensional crosslinking polymer matrix and the monomer to be compatible with each other, but it is also necessary for the matrix to be compatible with a polymer formed by polymerization of the monomer during recording; combinations of the polymer matrix precursor and the monomer that can satisfy the independence from the crosslinking reaction of the polymer matrix precursor and compatibility before and after recording are limited, and with respect to the optical product disclosed in JP-A-11-352303, the sensitivity is insufficient, the difference in refractive index is small, and the storage stability after recording is insufficient.
(Patent Publication 1) JP-B-06-100827
(Patent Publication 2) Japanese registered patent No. 2873126
(Patent Publication 3) Published Japanese translation No. 2001-523842 of a PCT application
(Patent Publication 4) JP-A-05-107999
(Patent Publication 5) JP-A-11-352303

As described above, various types of material systems have been disclosed for forming volume hologram recording films, but no material has been provided that has high sensitivity with good storage stability after recording, a large interference fringe refractive index difference, and is suitable for use in a data recording system.

The present invention has been accomplished under the above-mentioned circumstances, and it is an object thereof to provide a hologram recording material that has high sensitivity, gives a large refractive index difference, and has excellent storage stability after recording, and a volume hologram recording medium employing same.

The present invention relates to a volume hologram recording material comprising a polymer matrix having a three-dimensional crosslinking structure having a plurality of reactive groups, the polymer matrix being capable of recording, by means of refractive index difference, interference fringes that result from the interference of coherent light, the material not having a polymerizable monomer as a constituent for recording a hologram.

In accordance with use of the volume hologram recording material of the present invention, it is possible to produce a volume hologram recording medium that has high sensitivity, gives high diffraction efficiency, has excellent storage stability after recording, and requires no step of dissolving in a solvent and drying when forming a recording layer.

Since it is unnecessary to use a polymerizable monomer having a flash point, safety during production, handling, transport, etc. of a recording medium is excellent.
(FIG. 1) A diagram showing the constitution of diffraction efficiency measurement equipment.
(FIG. 2) A cross-sectional view of a sample cell prepared in Examples 3 and 4.
(FIG. 3) Reproduced images of data recorded with an energy of 1000 pulses in Examples 3 and 4, (A) is a reproduced image of Example 3, and (B) is a reproduced image of Example 4.

### Matrix polymer

Examples of polymerization reactions that can be used for formation of a matrix polymer having a three-dimensional crosslinking structure in the present invention include cationic epoxy polymerization, cationic vinyl ether polymerization, cationic alkenyl ether polymerization, cationic allene ether polymerization, cationic ketene acetal polymerization, epoxy-amine addition polymerization, epoxy-thiol addition polymerization, unsaturated ester-amine addition polymerization (involving Michael addition), unsaturated ester-thiol addition polymerization (involving Michael addition), vinyl-silicon hydride addition polymerization (hydrosilylation), isocyanate-hydroxyl addition polymerization (urethane formation), isocyanate-thiol addition polymerization, and isocyanate-amine addition polymerization (urea formation).

The above-mentioned reactions are made possible or promoted by an appropriate catalyst. For example, cationic epoxy polymerization proceeds rapidly at room temperature by the use of a catalyst containing BF₃ as a main component, other cationic polymerizations proceed in the presence of protons, an epoxy-mercaptan reaction and Michael addition are promoted by a base such as an amine, hydrosilylation proceeds rapidly in the presence of a transition metal catalyst such as platinum, and the formation of a urethane or a urea proceeds rapidly by the use of a tin catalyst.

It is preferable to employ isocyanate-hydroxyl addition polymerization, isocyanate-thiol addition polymerization, or epoxy-thiol addition polymerization since it is possible to ensure an appropriate pot life and to use them at a moderate curing temperature.

Starting compounds that can be used for the above addition polymerizations are explained below.

### 1) Polyisocyanate

Examples of polyisocyanates that can be used in the isocyanate-hydroxyl addition polymerization or the isocyanate-thiol addition polymerization include tolylene diisocyanate, 4,4'-diphenylmethane diisocyanate, 4,4'-dicyclohexylmethane diisocyanate, hexamethylene diisocyanate, isophorone diisocyanate, and biurets, isocyanurates, adducts, and prepolymers of these isocyanates.

### 2) Polyol

Examples of polyols that can be used in the isocyanate-hydroxyl addition polymerization include low molecular weight polyols, polyether polyols, polyester polyols, polycaprolactones, and polycarbonate diols. Examples of the low molecular weight polyol include ethylene glycol, propylene glycol, cyclohexanedimethanol, 3-methyl-1,5-pentanediol, glycerol, trimethylolpropane, ethylene oxide-modified derivatives thereof, and propylene oxide-modified derivatives thereof.

Examples of the polyether polyols include polyethylene glycol, polypropylene glycol, and polytetramethylene glycol, and examples of the polyester polyols include reaction products of ethylene glycol, propylene glycol, cyclohexanedimethanol, or 3-methyl-1,5-pentanediol with an acid component such as a dibasic acid such as adipic acid, succinic acid, phthalic acid, hexahydrophthalic acid, or terephthalic acid, or the acid anhydride thereof.

### 3) Thiol

Examples of thiol compounds that can be used in the isocyanate-thiol addition polymerization include simple thiols, thioglycolic acid derivatives, and mercaptopropionic acid derivatives. Examples of the simple thiols include o-, m-, and p-xylenedithiols.

Examples of the thioglycolic acid derivatives include ethylene glycol bisthioglycolate, butanediol bisthioglycolate, and hexanediol bisthioglycolate.

Examples of the mercaptopropionic acid derivatives include ethylene glycol bisthiopropionate, butanediol bisthiopropionate, trimethylolpropane tristhiopropionate, pentaerythritol tetrakisthiopropionate, and trihydroxyethyltriisocyanuric acid tristhiopropionate.

### 4) Epoxy

Examples of epoxy compounds that can be used in the epoxy-thiol addition polymerization include polyglycidyl ethers of polyols such as (poly)ethylene glycol, (poly)propylene glycol, trimethylolpropane, and glycerol, alicyclic epoxies, bisphenol A epoxy resins, and phenol or cresol novolac epoxy resins.

### 5) Crosslinking reactive group of matrix polymer

In the present invention, introducing a plurality of crosslinking reactive groups into a polymer matrix having a three-dimensional crosslinking structure enables hologram recording to be carried out. That is, the crosslinking reactive groups undergo a crosslinking reaction on irradiation with energy rays that generate interference fringes within the polymer matrix by interference of coherent light, thus generating within the polymer matrix differences in refractive index corresponding to the interference fringes.

The plurality of crosslinking reactive groups are present in a dispersed manner at different positions of the three-dimensional crosslinking polymer matrix, and high density crosslinking due to the crosslinking reactive groups is produced in a region that is irradiated with energy rays, thus causing a difference in refractive index from a region that is not irradiated with energy rays while maintaining a high level of transparency and thereby enabling volume hologram recording to be carried out.

As a result, it is possible to increase diffraction efficiency after recording and easily carry out reading of recorded data.

When the isocyanate-hydroxyl addition polymerization is utilized, with regard to a starting compound that can be used for incorporating the reactive group, a compound having both a hydroxyl group and a reactive group, or a compound having both an isocyanate group and a reactive group may be used; the compound having a hydroxyl group and a reactive group, which is readily available industrially, is preferable, and examples thereof include a (meth)acrylate compound having a hydroxyl group.

Examples of the (meth)acrylate compound having a hydroxyl group include an adduct between an epoxy compound and (meth)acrylic acid, which is known as an epoxy (meth)acrylate and, furthermore, the (meth)acrylic acid adduct of a polyglycidyl ether of a polyol such as (poly)ethylene glycol, (poly)propylene glycol, trimethylolpropane, or glycerol, the (meth)acrylate of a bisphenol A epoxy resin, and the (meth)acrylate of a phenol or cresol novolac epoxy resin.

When the isocyanate-thiol addition polymerization or the epoxy-thiol addition polymerization is utilized, with regard to a method for incorporating the reactive group, a method may be selected in which a matrix is cured in the presence of a polyene monomer using an excess amount of a thiol compound, and the polyene and the thiol group remaining in the matrix are then subjected to radical addition polymerization.

The concentration of the reactive group in the polymer matrix having a three-dimensional crosslinking structure is preferably 0.2 to 10 mol/kg, and more preferably 0.4 to 5 mol/kg. If there are too many reactive groups, a recorded image might be distorted due to curing shrinkage of the matrix during recording, and if there are too few reactive groups, there is a possibility that sufficient diffraction efficiency might not be obtained or that storage stability after recording might become poor.

### Other components

### Nonreactive resin

Nonreactive compounds are compounds having no reactivity with the polymer matrix, and are components that have an effect of enhancing the mobility of the crosslinking reactive group bonded to the polymer matrix by being contained in the material of the present invention, and thereby improving the reactivity of the crosslinking reactive group toward energy rays. Among them, those having plasticity (plasticizers) are included, and a plasticizer having a low refractive index is particularly preferable in the present invention.

Preferred examples of the nonreactive compounds include phthalic acid esters represented by dimethyl phthalate, diethyl phthalate, and dioctyl phthalate; aliphatic dibasic acid esters represented by dimethyl adipate, dibutyl adipate, dioctyl adipate, dimethyl sebacate, diethyl sebacate, dibutyl sebacate, and diethyl succinate, and aliphatic polybasic acid esters such as tributyl acetylcitrate; orthophosphoric acid esters represented by trimethyl phosphate, triethyl phosphate, triphenyl phosphate, and tricresyl phosphate; acetic acid esters represented by glyceryl triacetate and 2-ethylhexyl acetate; phosphorous acid esters represented by triphenyl phosphite and dibutyl hydrogen phosphite; and inactive compounds such as polyesters, acrylic polymers, polyethers, and petroleum resins.

A preferred proportion of the nonreactive compound is equal to or less than 30 parts by weight relative to 100 parts by weight of the material of the present invention.

### Photopolymerization initiator

The photopolymerization initiator is appropriately selected from a radical photopolymerization initiator, a cationic photopolymerization initiator, etc. according to the type of crosslinking reaction of the reactive group.

Examples of the radical photopolymerization initiator include 1,3-di(*t-*butyldioxycarbonyl)benzophenone, 3,3',4,4'-tetrakis(*t*-butyldioxycarbonyl)benzophenone, N-phenylglycine, 2,4,6-tris(trichloromethyl)-*s*-triazine, 3-phenyl-5-isooxazolone, 2-mercaptobenzimidazole, imidazole dimers, bis(η⁵-2,4-cyclopentadien-1-yl)bis[2,6-difluoro-3-(1H-pyrrol-1-yl)phenyl]titanium, which is commercially available as CGI-784 from Ciba, and 5,7-diiodo-3-butoxy-6-fluorone, which is commercially available as H-Nu470 from Spectra Group Limited.

Examples of the cationic photopolymerization initiator include aromatic diazonium salts, aromatic iodonium salts, aromatic sulfonium salts, aromatic phosphonium salts, mixed-ligand metal salts such as, for example, (η⁶-benzene)(η⁵-cyclopentadienyl) iron (II), and silanol-aluminum complexes.

### Sensitizing dye

In order to enhance the sensitivity toward each laser light wavelength, a sensitizing dye may be added.

Preferred examples of the sensitizing dye include xanthene, thioxanthene, cyanine, merocyanine, coumarin, ketocoumarin, eosin, erythrosin, titanocene, naphthacene, thiopyrylium, quinoline, styrylquinoline, oxonole, cyanine, rhodamine, and pyrylium-based compounds. When high transparency is required, a sensitizing dye that has an absorption wavelength in the visible light region is preferably one that becomes colorless as a result of decomposition, etc. by heating or UV irradiation in a post-treatment subsequent to hologram recording.

### Tertiary amine

In the present invention, adding a tertiary amine enables the sensitivity to be enhanced.

Preferred specific examples thereof include triethylamine, tributylamine, triethanolamine, *N*,*N*-dimethylbenzylamine, methyl dimethylaminobenzoate, and amino (meth)acrylates having a tertiary amino group such as dimethylaminoethyl acrylate and amine (meth)acrylates formed by partially or fully adding a primary or secondary amine to the (meth)acryloyl group of a monofunctional or polyfunctional (meth)acrylate. A preferred amount thereof added is 0.1 to 10 weight %.

### Volume hologram recording medium

With regard to a preferred embodiment of a process for producing a volume hologram recording medium, there is a method in which the composition of the present invention is injected into a transparent support. With regard to a specific method for injecting into a transparent support, there are a method in which a pair of transparent supports are disposed so that the transparent supports are provided on either side of a recording layer that is to be formed, and a composition is injected between the two transparent supports, a method in which an injection hole is provided in a box-shaped transparent support and a composition is injected therefrom, and a method in which one face of a box-shaped transparent support is made open, a composition is injected or added dropwise, and the open face is then sealed by covering with a transparent support.

Alternatively, coating of an appropriate substrate may be carried out by a method employing a spin coater, a gravure coater, a comma coater, a bar coater, etc.

The thickness of the volume hologram recording material layer is preferably 10 to 2000 µm, and more preferably 100 to 1000 µm.

The substrate of a volume hologram recording photosensitive medium is one having transparency, and examples thereof include a glass and resins such as polycarbonate, polyethylene, polypropylene, polyethylene fluoride, polyvinylidene fluoride, polyvinyl chloride, polyvinylidene chloride, ethylene-vinyl alcohol, polyvinyl alcohol, polymethyl methacrylate, polyether sulfone, polyether ether ketone, polyamide, a tetrafluoroethylene-perfluoroalkyl vinyl ether copolymer, polyesters such as polyethylene terephthalate, and polyimide.

The modulus of elasticity of the recording layer is preferably in the range of 10⁵ Pa to 10⁹ Pa at a normal temperature of use of 0°C to 50°C. If it is less than 10⁵ Pa, sufficient diffraction efficiency might not be obtained, or the storage stability after recording might become poor. If it is greater than 10⁹ Pa, the sensitivity might be degraded.

It is therefore preferable for the modulus of elasticity of the polymer matrix that is mixed with the nonreactive compound as appropriate to be also in the above-mentioned range.

### Hologram recording

For recording a hologram, visible laser light is used, for example, laser light from an argon ion laser (458 nm, 488 nm, 514.5 nm), a krypton ion laser (647.1 nm), a YAG laser (532 nm), etc., and hologram data are recorded in a recording layer by a standard method.

By a post-treatment such as an overall exposure treatment after recording, the storage stability after recording may be further enhanced.

### Method for recording on recording medium

With regard to the hologram recording method, there are a polarized collinear hologram recording method, a multiple angle of incidence reference light hologram recording method, etc., and when the volume hologram recording material of the present invention is used as a recording medium, since reference light and information light are on the same axis, high precision positioning is possible and anti-vibration measures are easily carried out, and the polarized collinear hologram recording method is therefore preferable.

### Uses of volume hologram recording material

Other than the volume hologram recording medium, uses and application fields for the volume hologram recording material of the present invention include optical devices, incorporation into displays/designs, interference measurement, optical information processing, and optical information recording.

Specific examples of the optical devices include diffraction gratings, POS scanners, CD/DVD player optical heads, beam splitters, interference filters, and airplane/automobile head-up displays.

Specific examples of the incorporation into displays/designs include hologram art, indoor/outdoor decoration, recording of arts and crafts, educational materials, book/magazine covers and illustrations, embellishment and forgery prevention of securities, ID cards, credit cards, cash cards, telephone cards, etc., and stereoscopic viewing of a CT image.

Specific examples of the interference measurement include measurement of displacement and deformation of an object, measurement of vibration of an object, and measurement of precision of an optical face (computer-generated hologram).

Specific examples of the optical information processing include pattern identification employing a holographic matched filter, and finger print verification.

Specific examples of the optical information recording include image recording for (high-definition or digital) television broadcasting, video camera pictures, and surveillance camera pictures, information retrieval recording, graphic character input devices, and holographic associative memory.

### Examples

### Examples 1 and 2

### Preparation of sample cell

A mixture of Table 1 below was stirred at 30°C to 40°C for 2 hours so as to fully dissolve it. 200 µm thick ethylene tetrafluoride sheets were affixed as spacers to three edges of a slide glass, a further slide glass was laid on top, and the periphery was fixed by clips to give a sample cell. The mixture was injected into the cell from one edge of the sample cell, and the matrix was cured by allowing it to stand at room temperature overnight, thus giving a recording layer formed from a polymer matrix having a three-dimensional crosslinking structure with a reactive group incorporated therein.

**(Table 1)**

| Composition of liquid mixture formulation | | | | | | | |
|---|---|---|---|---|---|---|---|
| | 80MFA¹⁾ | G-400²⁾ | HDI³⁾ | DBTL⁴⁾ | ATBC⁵⁾ | Irg784⁶⁾ | DMBA⁷⁾ |
| Ex. 1, 3 | 40 | 60 | 65 | 0.02 | | 2.6 | 3.6 |
| Ex. 2, 4 | 40 | 60 | 65 | 0.02 | 30 | 3.1 | 4.3 |

| | | | | | | | |
|---|---|---|---|---|---|---|---|
| 1) 80MFA: Epolite 80MFA, the epoxy diacrylate of glycerol diglycidyl ether, manufactured by Kyoeisha Chemical Co., Ltd. 2) G-400: glycerol propylene oxide-modified form (molecular weight 400) manufactured by Asahi Denka Co., Ltd. 3) Duranate HDI: hexamethylene diisocyanate, manufactured by Asahi Kasei Corp. 4) DBTL: dibutyltin dilaurate, manufactured by Asahi Denka Co., Ltd. 5) ATBC: tributyl acetylcitrate 6) Irgacure 784: bis(η⁵-2,4-cyclopentadien-1-yl)bis[2,6-difluoro-3-(1H-pyrrol-1-yl)phenyl] titanium, manufactured by Ciba Specialty Chemicals 7) DMBA: N,N-dimethylbenzylamine | | | | | | | |

### Measurement of diffraction efficiency

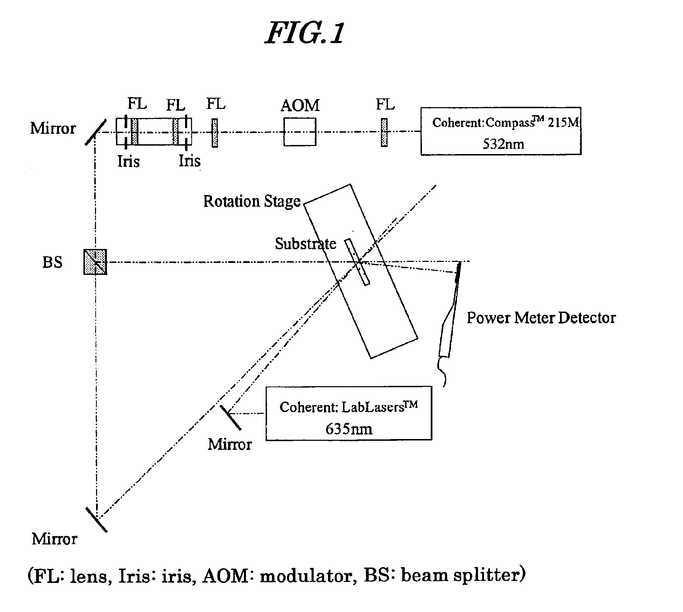

The recording layer so formed was subjected to two beam interference exposure using a green laser at a wavelength of 532 nm (Compass 215M, manufactured by Coherent) (FIG. 1). At the same time as the two beam interference exposure, the hologram formation process was monitored using a red laser at a wavelength of 635 nm (LabLasers, manufactured by Coherent), and the diffraction efficiency was evaluated. The diffraction light intensity was measured using a power meter (Optical Power Multimeter, manufactured by Advantest). The intensity of the green laser was 20 mW/cm² (measured at the front face of the substrate), and the intensity of the red laser was 1 µW/cm² (measured at the front face of the substrate).

### Storage stability test

After the sample cell was exposed to light under the above-mentioned conditions for diffraction efficiency measurement for 40 sec. and then left to stand for 1 hour, it was heated in an oven at 40°C for 24 hours, and cooled to room temperature, and the diffraction efficiency was then measured using a red laser at a wavelength of 635 nm.

Measurement results of the sample cells of Examples 1 and 2 are given in Table 2 below.

**(Table 2)**

| | After 5 sec. exposure time | After 40 sec. exposure time | After storage stability test |
|---|---|---|---|
| Ex. 1 | 5% | 11% | 9% |
| Ex. 2 | 10% | 25% | 22% |

### Examples 3 and 4

### Hologram information recording using recording medium

### Preparation of sample cell

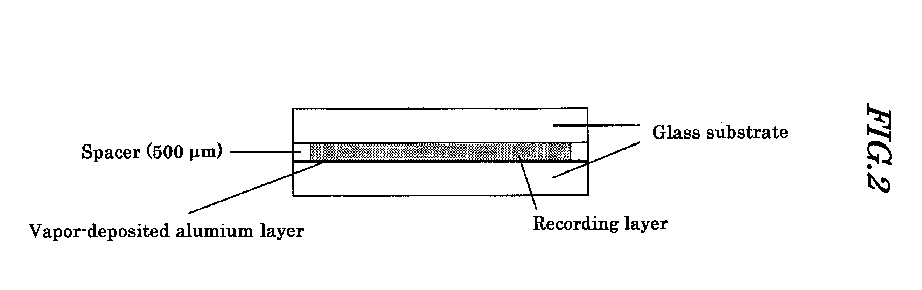

A sample cell was prepared by the same procedure as in Examples 1 and 2 using a mixture shown in Table 1 above. However, one of the glass substrates (50 x 50 x 1 mm) was changed for one with a vapor-deposited aluminum layer (reflection layer), the spacers were 500 µm, and the thickness of the recording layer was 500 µm (the cross section is shown in FIG. 2).

A heating step for forming a polymer matrix employed 80°C and 2 hours instead of the heating conditions (30°C to 40°C, 2 hours) of Example 1.

### Data recording

Information recording was carried out using the recording medium on which the recording layer had been formed by the above-mentioned procedure by means of an SVRD collinear hologram information recorder manufactured by Optware under the conditions below. The recording medium was set in a holder so that laser irradiation during playback was carried out from the direction of the upper face in FIG. 2, and the position was adjusted so that the laser came to focus on the vapor-deposited aluminum layer (reflection layer). Reading was carried out 30 sec. after writing.

The information pattern employed a standard pattern (test information pattern having about 1600 bytes).

### (Data recording conditions)

Playback laser wavelength: 532 nm (Nd: YV04)
Recording laser intensity: 1.5 mW (pulse width 10 nsec, repetition interval 50 µsec)
Information light / reference light intensity ratio = 3
Number of recording pulses: 200, 1000, 2000 pulses

### (Data reading conditions)

Read laser intensity: 0.75 mW to 0.1 mW (pulse width 10 nsec, repetition interval 50 µsec, adjusted by intensity of CMOS image)
Number of read pulses: 10 pulses.

**(Table 3)**

| Error rate of recorded data (bit error rate) | | | |
|---|---|---|---|
| Number of pulses | 200 | 1000 | 2000 |
| Ex. 3 | >10⁻¹ | <10⁻⁴ | <10⁻⁴ |
| Ex. 4 | <10⁻⁴ | <10⁻⁴ | 1 x 10⁻³ |

In Table 3 above, in which the error rate of recorded data is shown, in Example 3 the bit error rate can be seen to have deteriorated when recording was carried out with an energy of 200 pulses, but the bit error rate did not deteriorate at all for recording with 1000 pulses and 2000 pulses, and in Example 4, hardly any deterioration in the bit error rate could be seen.

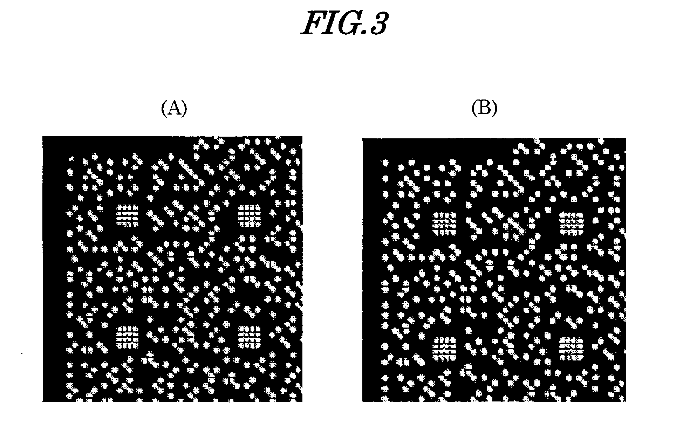

A playback image of data recorded with an energy of 1000 pulses as described above is shown in FIG. 3.

In both Examples 3 and 4, when recording was carried out with an energy of 1000 pulses, there was no distortion or blurring of reproduced images.

The storage modulus E of the recording material of each Example was as follows.

### Example 1: 8 x 10⁶ Pa

### Example 2: 5 x 10⁵ Pa

The recording material of the present invention is suitable for a volume hologram recording medium, and when forming a recording layer, it does not require a step of dissolving in a solvent and drying.

The recording medium comprising the recording material of the present invention has high diffraction efficiency, high sensitivity, and excellent storage stability after recording, and it is therefore useful as a recording medium for storing high capacity hologram data for a long period of time.

## Claims

1. A volume hologram recording material comprising a polymer matrix having a three-dimensional crosslinking structure having a plurality of reactive groups, the polymer matrix being capable of recording, by means of refractive index difference, interference fringes that result from the interference of coherent light, the material not having a polymerizable monomer as a constituent for recording a hologram.

2. The volume hologram recording material according to Claim 1, wherein the material comprises a polymer matrix having a three-dimensional crosslinking structure in which a plurality of crosslinking reactive groups are present in a dispersed manner, the crosslinking reactive groups undergoing a crosslinking reaction on irradiation with energy rays that generate interference fringes within the polymer matrix by interference of coherent light, and differences in refractive index corresponding the interference fringes being generated within the polymer matrix.

3. The volume hologram recording material according to either Claim 1 or Claim 2, wherein the material comprises as constituents a polymer matrix having a three-dimensional crosslinking structure having a plurality of reactive groups and a tertiary amine compound.

4. The volume hologram recording material according to any one of Claim 1 to Claim 3, wherein the material further comprises as a constituent a nonreactive compound that is compatible with the polymer matrix.

5. The volume hologram recording material according to any one of Claim 1 to Claim 4, wherein the polymer matrix is formed by addition polymerization of a polyol and a polyisocyanate.

6. The volume hologram recording material according to any one of Claim 1 to Claim 5, wherein the reactive group is a radically polymerizable group.

7. The volume hologram recording material according to any one of Claim 1 to Claim 6, wherein the concentration of the reactive group in the polymer matrix is at least 0.2 mol/kg but no greater than 10 mol/kg.

8. A volume hologram recording medium for recording, by means of refractive index difference, interference fringes that result from the interference of coherent light, the medium comprising a recording layer having a thickness of 100 µm or greater, and the recording layer comprising the volume hologram recording material according to any one of Claim 1 to Claim 7.
